# EUROPÄISCHE PATENTSCHRIFT

(11) **EP 1 031 026 B1**
(45) Veröffentlichungstag und Bekanntmachung des Hinweises auf die Patenterteilung: **29.01.2003**
(21) Anmeldenummer: 98962183.4
(22) Anmeldetag: 26.10.1998
(51) Int. Cl.: G01N 21/88, G01R 31/309

(54) **VORRICHTUNG ZUR LAGEERFASSUNG VON BAUELEMENTEN , LICHTUMLENKKÖRPER UND BESTÜCKKOPF MIT EINER VORRICHTUNG ZUR LAGEERFASSUNG VON BAUELEMENTEN**
DEVICE FOR DETECTING THE LOCATION OF COMPONENTS, LIGHT DEFLECTION BODY AND INSERTION HEAD WITH A DEVICE FOR DETECTING THE LOCATION OF COMPONENTS
DISPOSITIF PERMETTANT DE DETECTER LA POSITION DES COMPOSANTS, DISPOSITIF POUR LA DEVIATION LUMINEUSE ET TETE POUR L'IMPLANTATION AUTOMATIQUE DE COMPOSANTS

(30) Priorität: 10.11.1997 DE 19749652
(43) Veröffentlichungstag der Anmeldung: 30.08.2000
(73) Patentinhaber: SIEMENS AKTIENGESELLSCHAFT, 80333 München (DE)
(72) Erfinder: STREDELE, Bernhard, D-82449 Uffing (DE); SCHNELLINGER, Stefan, D-81371 München (DE); WITTMANN, Günther, D-80796 München (DE); GRASMÜLLER, Hans-Horst, D-82291 Mammendorf (DE)
(86) Internationale Anmeldenummer: DE9803140
(87) Internationale Veröffentlichungsnummer: WO99024818

(56) Entgegenhaltungen:
- EP-A- 0 243 680
- EP-A- 0 461 395
- DE-A- 4 123 916
- DE-A- 4 426 968
- US-A- 5 396 334

## Beschreibung

Die Erfindung bezieht sich auf einen Lichtumlenkkörper für eine Vorrichtung zur Lageerfassung von Bauelementen und/oder zur Überprüfung der Lage von Anschlüssen von Bauelementen. Die Erfindung betrifft ferner eine Vorrichtung zur Lageerfassung von Bauelementen, die den Lichtumlenkkörper umfasst. Außerdem betrifft die Erfindung einen Bestückkopf mit der oben genannten Vorrichtung.

Bei der automatischen Bestückung von Leiterplatten mit Bauelementen werden die Bauelemente aus Zuführeinrichtungen mittels eines Bestückkopfes abgeholt und auf der dem jeweiligen Bauelement zugeordneten Position auf der Leiterplatte abgesetzt. Damit die relative Position des Bauelementes zur Leiterplatte genau eingehalten wird, werden die Bauelemente in einer Vorrichtung zur Lageerfassung beleuchtet, mittels einer Kamera wird ein Bild der aktuellen Position des Bauelementes am Bestückkopf aufgenommen und in einer der Kamera nachgeschalteten Bildauswerteeinheit mit einer vorgegebenen Position verglichen. Der Bestückkopf transportiert anschließend das Bauelement unter Berücksichtigung der aktuellen Position auf die vorgebene Position auf der Leiterplatte. Für die Montage von Bauelementen ohne Gehäuse, deren Anschlüsse flächig über die gesamte Oberfläche des Bauelementes verteilt sind (Flip-Chip-Montage) wird die Lageerfassung anhand der Anschlußpositionen durchgeführt.

Aus EP 0 243 680 ist eine Vorrichtung zur Auflichtbeleuchtung bekannt, die für die Lageerkennung von Leiterbahnen oder Justierstrukturen auf Leiterplatten Mittel zur gleichzeitigen Beaufschlagung der Leiterplattenoberfläche mit senkrecht einfallenden Strahlen und allseitig schräg einfallenden Strahlen umfaßt. Die Begriffe senkrecht und im weiteren horizontal sind in Bezug auf die Bauelementoberfläche, die ihrerseits im wesentlichen senkrecht zur optischen Achse der Abbildung liegt, zu verstehen. Vor allem die Anschlüsse bei der Flip-Chip-Montage werden dabei nur schlecht beleuchtet und können in der Bildauswerteeinheit nicht eindeutig erkannt werden.

Aus DE 44 26 968 A1 ist ein Lichtleiter bekannt, der für die seitliche Beleuchtung eines Objekts verwendbar ist. Der Lichtleiter hat Wandungen, an denen das von den Seitenflächen des Objekts reflektierte Licht zu einem optischen Inspektionssystem hin abgelenkt wird. Dadurch können die Seitenflächen und die Oberseite des zu beobachtenden Objekts optisch geprüft werden. Reflektierende Oberflächenstrukturen sind durch das seitlich einfallende Licht allerdings nur sehr schwer zu erkennen. Ein separater Lichtleiter läßt sich auch nur schwer in einen Bestückprozeß integrieren.

Aus EP 0 725 560 ist eine Vorrichtung zur Lageerfassung von von Bauelementen bei der Bestückung bekannt, bei der Lichtquellen für senkrecht und allseitig schräg einfallendes Licht vorgesehen sind, sowie eine Kamera mit nachgeschalteter Bildauswerteeinheit. Zusätzlich ist eine dritte Lichtquelle für horizontal auf die Seitenflächen des Bauelementes einfallendes Licht vorgesehen. Diese dritte Lichtquelle dient als Durchlichtbeleuchtungsquelle für einen weiteren Lichtsensor. Diese Konstruktion ist aufwendig und erfordert separate Auswertungen von der Kamera und dem Lichtsensor.

Es ist daher Aufgabe der Erfindung, die aus der EP 0 725 560 bekannte Vorrichtung so weiterzubilden, daß eine weniger aufwendige Konstruktion erforderlich ist und die Auswertung der optischen Information vereinfacht wird. Die Aufgabe der Erfindung besteht ferner darin, einen für die weitergebildete Vorrichtung geeigneten Lichtumlenkkörper sowie einen Bestückkopf mit der weitergebildeten Vorrichtung zu schaffen.

Die Aufgabe wird durch einen Lichtumlenkkörper gemäß Anspruch 1 sowie durch einen Bestückkopf gemäß Anspruch 13 gelöst. Die Aufgabe wird ferner durch eine Vorrichtung für die Lageerfassung von Bauelementen und/oder für die Überprüfung der Lage von Anschlüssen von Bauelementen mit den Merkmalen des Anspruchs 4 gelöst.

Bei der erfindungsgemäßen Vorrichtung nach Anspruch 4 sind sowohl erste Mittel zum Beleuchten des Bauelementes mit allseitig schräg einfallendem Licht, als auch zweite Mittel zum Beleuchten der Seitenflächen des Bauelementes mit horizontal einfallendem Licht sowie dritte Mittel zum Beleuchten des Bauelementes mit senkrecht von oben einfallendem Licht vorgesehen. Die drei zum Beleuchten sind als Auflichtquellen ausgebildet und leuchten das Bildfeld einer einzigen Kamera aus. Damit können sowohl reflektierende Oberflächenstrukturen, als auch seitlich herausragende Anschlüsse beleuchtet werden.

Die zweiten Mittel zum Beleuchten des Bauelementes mit horizontal einfallendem Licht umfassen einen Lichtumlenkkörper nach einen der Ansprüche 1 bis 3, der das in ihn eingestrahlte Licht auf die Seitenflächen des zu erfassenden Bauelementes umlenkt, welches sich in einer Öffnung des Lichtumlenkkörpers befindet. Von oben lassen sich dadurch seitlich aus dem Bauelement heraustretende Strukturen leicht erkennen und für die Lageerfassung nutzen.

In einer bevorzugten Ausgestaltung nach Patentanspruch 5 wird das senkrecht einfallende Licht durch Lichtquellen erzeugt, die ihr Licht durch einen teildurchlässigen Spiegel in den Strahlengang der Beleuchtungseinrichtung einkoppeln. Durch eine Reflexion am teildurchlässigen Spiegel erfolgt eine Abbildung der Bauelemente auf eine Kamera.

Nach Patentanspruch 7 umfassen die ersten Mittel zum Beleuchten des Bauelementes mit allseitig schräg einfallendem Licht eine Spiegelanordnung. Diese ist gegenüber einer Ausgestaltung mit optischen Linsensystemen besonders leicht und läßt sich platzsparend in die Beleuchtungseinrichtung integrieren.

Die Lichtquellen für die Beleuchtungen mit senkrecht von oben einfallendem Licht, mit allseitig schräg und mit horizontal einfallendem Licht sind in platzsparenden, leichten und preiswert zu realisierenden Ausführungsformen nach den Ansprüchen 6, 8 und 9 als Leuchtdioden ausgebildet.

Eine besonders leichte Ausführung des Lichtumlenkkörpers ergibt sich nach Anspruch 10 durch die Herstellung desselben aus einem optisch transparenten Kunststoff.

Nach Anspruch 11 sind die Lichtquellen in dafür vorgesehenen Haltevorrichtungen des Lichtumlenkkörpers angeordnet, was zu einer guten Befestigung der Lichtquellen bei gleichzeitigem geringen Verlust von Lichtleistung führt.

In einer bevorzugten Ausgestaltung des Lichtumlenkkörpers nach Anspruch 2 weist der Lichtumlenkkörper Aussparungen auf, durch die die Bauelemente im wesentlichen horizontal und damit ohne eine technisch aufwendigere Vertikalbewegung in die Öffnung transportiert werden.

Eine besonders hohe Bestückleistung ergibt sich nach der vorteilhaften Ausgestaltung nach Patentanspruch 13 durch die Anbringung der Beleuchtungsvorrichtung an einem Bestückkopf, wodurch sichergestellt ist, daß der Bestückkopf nicht für jede Lageerkennung eine besondere Einrichtung zur Lageerkennung innerhalb des Bestückautomaten anfahren muß.

Anhand von Ausführungsbeispielen wird die Erfindung in den Figuren der Zeichnung näher erläutert.
Dabei zeigen
Figur 1 einen schematischen Querschnitt durch eine erfindungsgemäße Vorrichtung zur Lageerfassung
Figur 2 eine schematische Darstellung der Beleuchtungsarten
Figur 3 einen schematischen Querschnitt durch einen erfindungsgemäßen Lichtumlenkkörper entlang der Schnittachse A-A von Figur 4, in der eine Draufsicht auf den Lichtumlenkkörper dargestellt ist.

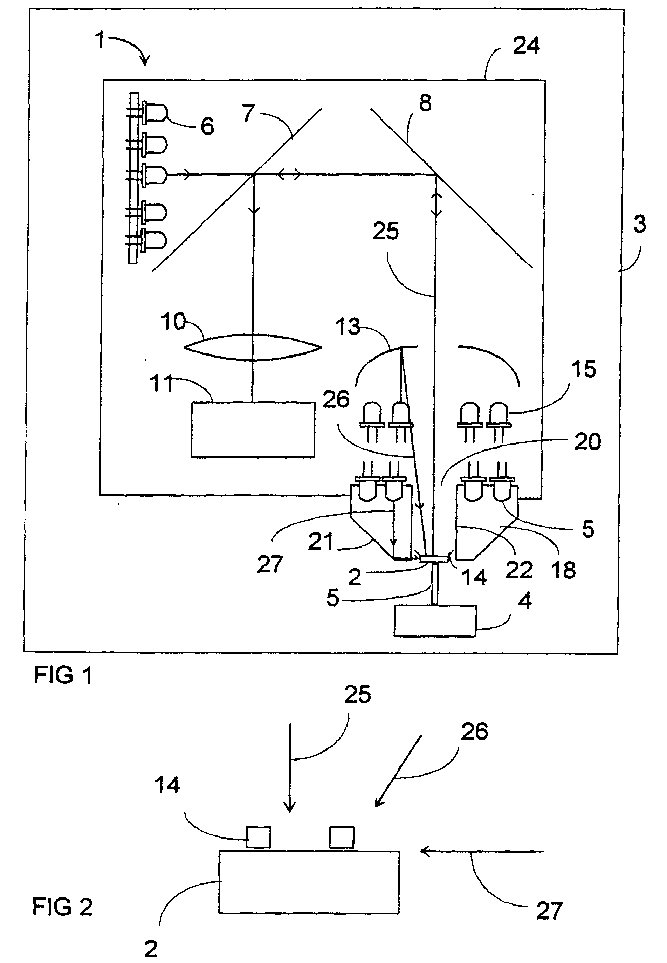

In Figur 1 ist eine Vorrichtung 1 für die Lageerfassung und/oder Überprüfung der Lage der Anschlüsse 14 eines Bauelementes 2 dargestellt. Die Vorrichtung 1 ist dabei so ausgelegt, daß sie vorzugsweise an einem Bestückkopf 3 eines Bestückautomaten befestigt wird. Der Bestückkopf 3 umfaßt dabei auch einen drehbar gelagerte Saugpipettenhalterung 4 (Revolverkopf) mit Saugpipetten 5 zur Aufnahme der Bauelemente 2 aus einer nicht dargestellten Zuführeinrichtung. Die Vorrichtung weist dabei erste Mittel zum Beleuchten eines Bauelementes 2 mit senkrechtem Lichteinfall 25 von oben auf, wobei besonders gut reflektierende Oberflächen des Bauelementes 2 wie beispielsweise Leiterbahnen oder Kontakte 14 erkannt werden, die eine planare Oberfläche besitzen. Für diese Art der Beleuchtung ist eine erste Lichtquelle vorgesehen, die eine ersten Gruppe von Leuchtdioden 6 umfaßt, deren emittiertes Licht durch einen ersten Spiegel 7, der teildurchlässig ausgebildet ist, hindurch und durch Reflexion an einem zweiten Spiegel 8 senkrecht auf die Oberfläche des Bauelementes 2 gelenkt wird. Die Abbildung des beleuchteten Bauelementes 2 erfolgt ebenfalls über den zweiten Spiegel 8 und den teildurchlässigen Spiegel 7, die das Bauelement über eine optische Abbildungseinrichtung 10, beispielsweise ein Objektiv, auf eine Kamera 11 in der Vorrichtung 1 zur Lagererkennung abbilden. Die Kamera 11 ist mit einer nicht dargestellten Bildauswerteeinheit verbunden, in der die Position des Bauelementes 2 am Bestückkopf 3 im Verhältnis zu einer vorgegebenen Sollposition bestimmt wird. Zusätzlich sind zweite Mittel zur Beleuchtung des Bauelementes 2 mit allseitig schräg einfallendem Licht 26 vorgesehen. Diese zweiten Mittel umfassen dabei eine zweite Lichtquelle, die aus einer zweiten Gruppe von Leuchtdioden 15 besteht und einer dritten Spiegelanordnung 13, die das von der zweiten Lichtquelle emittierte Licht so ablenkt, daß es allseitig schräg auf das Bauelement 2 auftrifft. Die Abbildung erfolgt wieder über den zweiten Spiegel 8 und den teildurchlässigen Spiegel 7 auf die Kamera 11.
Weiterhin sind dritte Mittel zur Beleuchtung des Bauelements 2 mit horizontal auf die Seitenflächen des Bauelementes 2 einfallendem Licht 27 vorgesehen, damit seitlich vom Bauelement 2 herausragende Strukturen, wie beispielsweise Anschlüsse 14 erkannt werden. Die drei Beleuchtungsarten sind in Figur 2 noch einmal deutlicher dargestellt. Diese dritten Mittel umfassen eine dritte Lichtquelle in Form einer dritten Gruppe von Leuchtdioden 16, die in Haltevorrichtungen 17 eines Lichtumlenkkörpers 18 befestigt sind. Der Lichtumlenkkörper 18 besteht aus einem transparenten Material wie Glas oder optisch transparentem Kunststoff (PC, Polycarbonat, Handelsname Makralon oder PMMA, Polymethacrylat, Handelsname Plexiglas). Das von der dritten Gruppe von Leuchtdioden 16 emittierte Licht wird im Lichtumlenkkörper 18 auf die Seitenflächen des Bauelementes 2 umgelenkt, welches sich in einer Öffnung 20 des Lichtumlenkkörpers 18 befindet. Die Abbildung erfolgt ebenfalls über den zweiten Spiegel 8 und den teildurchlässigen Spiegel 7 auf die Kamera 11. Anstelle des Lichtumlenkkörpers kann auch eine nicht dargestellte vierte Spiegelanordnung zur Umlenkung des Lichtes in die horizontale Ebene verwendet werden.

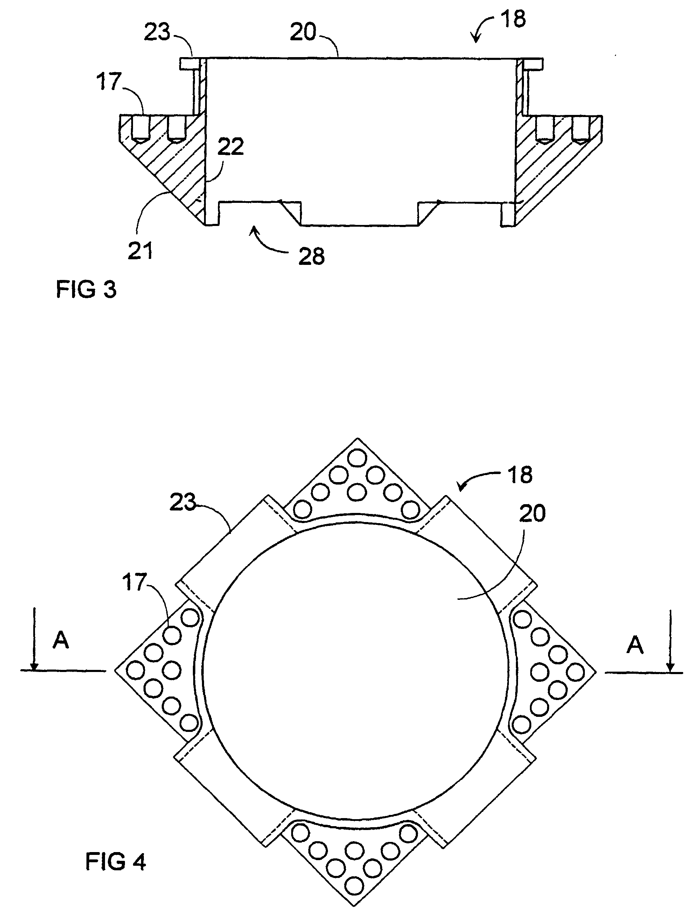

Der Lichtumlenkkörper 18 ist detaillierter in der Draufsicht in Figur 4 und im Schnitt entlang der Kante A-A in Figur 3 dargestellt. In den Haltevorrichtungen 17, die als Bohrungen ausgebildet sind, ist die dritte Gruppe von Leuchtdioden 16 befestigt. Diese emittieren ihr Licht in den Lichtumlenkkörper 18 hinein, dort wird das Licht durch Totalreflexion an einer ersten (äußeren) Wand 21 reflektiert und fällt durch eine zweite (innere) Wand 22 in die Öffnung 20 des Lichtumlenkkörpers 18 und damit auf die Seitenflächen des Bauelements 2. Der Lichtumlenkkörper 18 weist darüberhinaus Befestigungsvorrichtungen 23 auf, mit denen er lösbar in dem Gehäuse 24 der Vorrichtung 1 zur Lageerkennung befestigt wird. Durch die Öffnung 20 gelangt sowohl das senkrecht von oben einfallende Licht als auch das allseitig schräg einfallende Licht auf das Bauelement 2. Die Abbildung auf die Kamera 11 erfolgt ebenfalls durch die Öffnung 20 des Lichtumlenkkörpers 18. Für den im wesentlichen horizontalen Transport der Bauelement 2 in die Öffnung 20 weist der Lichtumlenkkörper 18 Aussparungen 28 auf. Damit wird eine technisch aufwendige Vertikalbewegung der Bauelemente 2 vermieden.

Die Anordnung mit Spiegeln (7,8,13) und Leuchtdioden (6, 12, 15) ist besonders leicht und platzsparend und kann daher an einem Bestückkopf 3 befestigt werden. Damit ergibt sich eine große Zeitersparnis beim Bestücken, da nicht eine separate Station zur Lageerkennung angefahren werden muß. Dadurch steigt die Bestückleistung des Bestückautomaten.

## Patentansprüche

1. Lichtumlenkkörper (18) mit einer Haltevorrichtung (17) für eine Lichtquelle (15), wobei die Haltevorrichtung (17) so ausgestaltet ist, daß das von der Lichtquelle (15) emittierte Licht in den Lichtumlenkkörper (18) gestrahlt wird,
mit einer Öffnung (20) für Bauelemente (2),
mit einer derart gestalteten ersten äußeren Wand (21), daß das in den Lichtumlenkkörper (18) hineingestrahlte Licht in Richtung der Öffnung (20) umgelenkt wird und durch eine der Öffnung zugeordnete innere zweite Wand (22) hindurch in Richtung auf die Seitenflächen des Bauelementes (2) gelangt
**dadurch gekennzeichnet,**
**daß** Befestigungsvorrichtungen (23) zur lösbaren Befestigung an einer Vorrichtung (1) zur Lageerfassung von Bauelementen (2) und/oder für die Überprüfung der Lage von Anschlüssen (14) von Bauelementen (2) vorgesehen sind.

2. Lichtumlenkkörper nach Anspruch 1,
**dadurch gekennzeichnet,**
**daß** Aussparungen (28) im Lichtumlenkkörper (18) vorgesehen sind, damit die Bauelemente (2) im wesentlichen horizontal in die Öffnung (20) transportiert werden können.

3. Lichtumlenkkörper (18) nach einem der Ansprüche 1 oder 2,
**dadurch gekennzeichnet,**
**daß** der Lichtumlenkkörper (18) aus einem optisch transparenten Kunststoff ausgebildet ist.

4. Vorrichtung (1) für die Lageerfassung von Bauelementen (2) und/oder für die Überprüfung der Lage von Anschlüssen (14) von Bauelementen (2) mit ersten Mitteln zum Beleuchten der Bauelemente (2) mit allseitig schräg einfallendem Licht (26), mit zweiten Mitteln zum Beleuchten der Bauelemente (2) mit horizontal auf die Seitenflächen der Bauelemente (2) einfallendem Licht (27), wobei die zweiten Mittel zum Beleuchten der Bauelemente (2) mit horizontal einfallendem Licht eine erste Lichtquelle (15) und einen Lichtumlenkkörper (18) nach einem der Ansprüche 1 bis 3 umfassen,
und mit einer Kamera (11) mit nachgeschalteter Bildauswerteeinheit, wobei die Kamera (11) das an den Anschlüssen (14) und/oder den Bauelementen (2) im wesentlichen senkrecht nach oben reflektierte Licht aufnimmt,
wobei dritte Mittel zum Beleuchten der Bauelemente (2) mit senkrecht von oben einfallendem Licht (25) vorgesehen sind und
wobei die drei Mittel zum Beleuchten als Auflichtquellen ausgebildet sind und das Bildfeld der einzigen Kamera (11) ausleuchten.

5. Vorrichtung (1) für die Lageerfassung von Bauelementen (2) und/oder für die Überprüfung der Lage von Anschlüssen (14) von Bauelementen (2) nach Anspruch 4,
**dadurch gekennzeichnet,**
**daß** die dritten Mittel zum Beleuchten der Bauelemente (2) mit senkrecht von oben einfallendem Licht eine zweite Lichtquelle (6) sowie einen ersten teildurchlässigen Spiegel (7) umfassen, durch den das Licht der zweiten Lichtquelle (6) auf das Bauelement (2) fällt.

6. Vorrichtung (1) für die Lageerfassung von Bauelementen (2) und/oder für die Überprüfung der Lage von Anschlüssen (14) von Bauelementen (2) nach Anspruch 5,
**dadurch gekennzeichnet,**
**daß** die zweite Lichtquelle aus einer ersten Gruppe von Leuchtdioden (6) ausgebildet ist.

7. Vorrichtung (1) für die Lageerfassung von Bauelementen (2) und/oder für die Überprüfung der Lage von Anschlüssen (14) von Bauelementen (2) nach einem der Ansprüche 4 bis 6,
**dadurch gekennzeichnet,**
**daß** die ersten Mittel zum Beleuchten der Bauelemente (2) mit allseitig schräg einfallendem Licht eine dritte Lichtquelle (12) und eine Spiegelanordnung (13) umfassen, die das von der dritten Lichtquelle (12) emittierte Licht so umlenkt, daß es allseitig schräg auf das Bauelement (2) fällt.

8. Vorrichtung (1) für die Lageerfassung von Bauelementen (2) und/oder für die Überprüfung der Lage von Anschlüssen (14) von Bauelementen (2) nach Anspruch 7 ,
**dadurch gekennzeichnet,**
**daß** die dritte Lichtquelle aus einer zweiten Gruppe von Leuchtdioden (12) ausgebildet ist.

9. Vorrichtung (1) für die Lageerfassung von Bauelementen (2) und/oder für die Überprüfung der Lage von Anschlüssen (14) von Bauelementen (2) nach einem der Ansprüche 4 bis 8,
**dadurch gekennzeichnet,**
**daß** die erste Lichtquelle aus einer dritten Gruppe von Leuchtdioden (15) ausgebildet ist.

10. Vorrichtung (1) für die Lageerfassung von Bauelementen (2) und/oder für die Überprüfung der Lage von Anschlüssen (14) von Bauelementen (2) nach einem der Ansprüche 4 bis 9,
**dadurch gekennzeichnet,**
**daß** der Lichtumlenkkörper (18) aus einem optisch transparenten Kunststoff ausgebildet ist.

11. Vorrichtung (1) für die Lageerfassung von Bauelementen (2) und/oder für die Überprüfung der Lage von Anschlüssen (14) von Bauelementen (2) nach einem der Ansprüche 4 bis 10,
**dadurch gekennzeichnet,**
**daß** der Lichtumlenkkörper (18) eine Haltevorrichtung (17) für die erste Lichtquelle (15) umfaßt, wobei die Haltevorrichtungen (17) so ausgestaltet ist, daß das von der ersten Lichtquelle (15) emittierte Licht in den Lichtumlenkkörper (18) gestrahlt wird.

12. Vorrichtung (1) für die Lageerfassung von Bauelementen (2) und/oder für die Überprüfung der Lage von Anschlüssen (14) von Bauelementen (2) nach einem der Ansprüche 4 bis 11,
**dadurch gekennzeichnet,**
**daß** Aussparungen (28) im Lichtumlenkkörper (18) vorgesehen sind, damit die Bauelemente (2) von im wesentlichen horizontal in die Öffnung (20) transportiert werden können.

13. Bestückkopf (3) mit einer am Bestückkopf angeordneten Vorrichtung (1) für die Lageerfassung von Bauelementen (2) und/oder für die Überprüfung der Lage von Anschlüssen (14) von Bauelementen (2) nach einem der Ansprüche 4 bis 12.

## Claims

1. Light-deflecting body (18) having a holding apparatus (17) for a light source (15), the holding apparatus (17) being configured in such a way that the light emitted by the light source (15) is radiated into the light-deflecting body (18),
having an opening (20) for components (2),
having a first outer wall (21), which is configured in such a way that the light radiated into the light-deflecting body (18) is deflected in the direction of the opening (20) and passes through an inner second wall (22), which is assigned to the opening, in the direction of the side areas of the component (2),
**characterized**
**in that** fixing apparatuses (23) for releasable fixing on an apparatus (1) for detecting the position of components (2) and/or for checking the position of connections (14) of components (2) are provided.

2. Light-deflecting body according to Claim 1,
**characterized**
**in that** cutouts (28) are provided in the light-deflecting body (18) in order that the components (2) can be transported essentially horizontally into the opening (20).

3. Light-deflecting body (18) according to either of Claims 1 and 2,
**characterized**
**in that** the light-deflecting body (18) is constructed from an optically transparent plastic.

4. Apparatus (1) for detecting the position of components (2) and/or for checking the position of connections (14) of components (2), having first means for illuminating the components (2) with light (26) which is obliquely incident on all sides, having second means for illuminating the components (2) with light (27) which is incident horizontally on the side areas of the components (2), the second means, for illuminating the components (2) with light (27) which is incident horizontally, comprising a first light source (15) and a light-deflecting body (18) according to one of Claims 1 to 3,
and having a camera (11) with an image evaluation unit connected downstream, the camera (11) receiving the light reflected essentially perpendicularly upwards at the connections (14) and/or the components (2), third means being provided for illuminating the components (2) with light (25) which is incident perpendicularly from above, and
the three means for illumination being constructed as reflected-light sources and fully illuminating the image field of the single camera (11).

5. Apparatus (1) for detecting the position of components (2) and/or for checking the position of connections (14) of components (2) according to Claim 4,
**characterized**
**in that** the third means for illuminating the components (2) with light which is incident perpendicularly from above comprise a second light source (6) and also a first partially transmissive mirror (7), through which the light from the second light source (6) falls onto the component (2).

6. Apparatus (1) for detecting the position of components (2) and/or for checking the position of connections (14) of components (2) according to Claim 5,
**characterized**
**in that** the second light source is constructed from a first group of light-emitting diodes (6).

7. Apparatus (1) for detecting the position of components (2) and/or for checking the position of connections (14) of components (2) according to one of Claims 4 to 6,
**characterized**
**in that** the first means for illuminating the components (2) with light which is obliquely incident on all sides comprise a third light source (12) and a mirror arrangement (13), which deflects the light emitted by the third light source (12) in such a way that it falls obliquely onto the component (2) on all sides.

8. Apparatus (1) for detecting the position of components (2) and/or for checking the position of connections (14) of components (2) according to Claim 7,
**characterized**
**in that** the third light source is constructed from a second group of light-emitting diodes (12).

9. Apparatus (1) for detecting the position of components (2) and/or for checking the position of connections (14) of components (2) according to one of Claims 4 to 8,
**characterized**
**in that** the first light source is constructed from a third group of light-emitting diodes (15).

10. Apparatus (1) for detecting the position of components (2) and/or for checking the position of connections (14) of components (2) according to one of Claims 4 to 9,
**characterized**
**in that** the light-deflecting body (18) is constructed from an optically transparent plastic.

11. Apparatus (1) for detecting the position of components (2) and/or for checking the position of connections (14) of components (2) according to one of Claims 4 to 10,
**characterized**
**in that** the light-deflecting body (18) comprises a holding apparatus (17) for the first light source (15), the holding apparatuses (17) being configured in such a way that the light emitted by the first light source (15) is radiated into the light-deflecting body (18).

12. Apparatus (1) for detecting the position of components (2) and/or for checking the position of connections (14) of components (2) according to one of Claims 4 to 11,
**characterized**
**in that** cutouts (28) are provided in the light-deflecting body (18) in order that the components (2) can be transported essentially horizontally into the opening (20).

13. Component-mounting head (3) having an apparatus (1), which is arranged on the component-mounting head, for detecting the position of components (2) and/or for checking the position of connections (14) of components (2), according to one of Claims 4 to 12.

## Revendications

1. Corps (18) déviant la lumière comportant
un système de fixation (17) pour une source de lumière (15), le système de fixation (17) étant conçu de telle sorte que la lumière émise par la source de lumière (15) rayonne dans le corps (18) déviant la lumière,
une ouverture (20) pour des composants (2),
une première paroi extérieure (21) conçue de telle sorte que la lumière, qui rayonne dans le corps (18) déviant la lumière, est déviée dans la direction de l'ouverture (20) et parvient, à travers une deuxième paroi intérieure (22) correspondant à l'ouverture, dans la direction des surfaces latérales du composant (2)
**caractérisé par le fait**
**qu'**il est prévu des systèmes de fixation (23) destinés à la fixation amovible sur un dispositif (1) destiné à la détection de la position de composants (2) et/ou au contrôle de la position des bornes (14) de composants (2).

2. Corps déviant la lumière selon la revendication 1
**caractérisé par le fait**
**qu'**il est prévu des entailles (28) dans le corps (18) déviant la lumière pour que les composants (2) puissent être transportés dans l'ouverture (20), essentiellement dans le sens horizontal.

3. Corps (18) déviant la lumière selon l'une des revendications 1 ou 2
**caractérisé par le fait**
**que** le corps (18) déviant la lumière est conçu en matière plastique optiquement transparente.

4. Dispositif (1) destiné à la détermination de la position de composants (2) et/ou au contrôle de la position des bornes (14) de composants (2) et comportant
des premiers moyens pour éclairer les composants (2) avec de la lumière (26) arrivant obliquement de tous les côtés (26),
des deuxièmes moyens pour éclairer les composants (2) avec de la lumière (27) arrivant horizontalement sur les surtaces latérales des composants (2), les deuxièmes moyens pour éclairer les composants (2) avec de la lumière arrivant horizontalement comprenant une première source de lumière (15) et un corps (18) déviant la lumière selon l'une des revendications 1 à 3,
et une caméra (11) avec une unité d'évaluation de l'image montée en aval, la caméra (11) recevant la lumière réfléchie principalement perpendiculairement vers le haut sur les homes (14) et/ou sur les composants (2),
des troisièmes moyens étant prévus pour éclairer les composants (2) avec de la lumière (25) arrivant perpendiculairement d'en haut et
les trois moyens pour éclairer étant conçus comme sources de lumière réfléchie et illuminant le champ de prise de vue de l'unique caméra (11).

5. Dispositif (1) destiné à la détermination de la position de composants (2) et/ou au contrôle de la position des bornes (14) de composants (2) selon la revendication 4
**caractérisé par le fait**
**que** les troisièmes moyens pour éclairer les composants (2) avec de la lumière arrivant perpendiculairement d'en haut comprennent une deuxième source de lumière (6), ainsi qu'un premier miroir (7) partiellement transparent, à travers lequel la lumière de la deuxième source de lumière (6) arrive sur le composant (2).

6. Dispositif (1) destiné à la détermination de la position de composants (2) et/ou au contrôle de la position des homes (14) de composants (2) selon la revendication 5
**caractérisé par le fait**
**que** la deuxième source de lumière est constituée par un premier groupe de diodes luminescentes (6).

7. Dispositif (1) destiné à la détermination de la position de composants (2) et/ou au contrôle de la position des bornes (14) de composants (2) selon l'une des revendications 4 à 6
**caractérisé par le fait que** les premiers moyens pour éclairer les composants (2) avec de la lumière arrivant obliquement de tous les côtés comprennent une troisième source de lumière (12) et un système de miroirs (13) qui dévie la lumière émise par la troisième source de lumière (12) de telle sorte qu'elle arrive obliquement de tous les côtés sur le composant (2).

8. Dispositif (1) destiné à la détermination de is position de composants (2) et/ou au contrôle de la position des homes (14) de composants (2) selon la revendication 7
**caractérisé par le fait**
**que** la troisième source de lumière est constituée par un deuxième groupe de diodes luminescentes (12).

9. Dispositif (1) destiné à la détermination de la position de composants (2) et/ou au contrôle de la position des homes (14) de composants (2) selon Tune des revendications 4 à 8
**caractérisé par le fait**
**que** la première source de lumière est constituée par un troisième groupe de diodes luminescentes (15).

10. Dispositif (1) destiné à la détermination de la position de composants (2) et/ou au contrôle de la position des homes (14) de composants (2) selon l'une des revendications 4 à 9
**caractérisé par le fait**
**que** le corps (18) déviant la lumière est conçu en matière plastique optiquement transparente.

11. Dispositif (1) destiné à la détermination de la position de composants (2) et/ou au contrôle de la position des homes (14) de composants (2) selon l'une des revendications 4 à 10
**caractérisé par le fait**
**que** le corps (18) déviant la lumière comporte un système de fixation (17) pour la première source de lumière (15), les systèmes de fixation (17) étant conçus de telle sorte que la lumière émise par la première source de lumière (15) rayonne dans le corps (18) déviant la lumière.

12. Dispositif (1) destiné à la détermination de la position de composants (2) et/ou au contrôle de la position de homes (14) de composants (2) selon Tune des revendications 4 à 11
**caractérisé par le fait**
**que** des entailles (28) sont prévues dans le corps (18) déviant la lumière pour que les composants (2) puissent être transportés dans l'ouverture (20) essentiellement dans le sens horizontal.

13. Tête (3) à insérer des composants comportant un dispositif (1), monté sur la tête à insérer et destiné à la détermination de la position de composants (2) et/ou au contrôle de la position des homes (14) de composants (2) selon l'une des revendications 4 à 12.
